# EUROPEAN PATENT APPLICATION

(11) **EP 0 778 468 A2**
(43) Date of publication of application: **11.06.1997**
(21) Application number: 96119549.2
(22) Date of filing: 05.12.1996
(51) Int. Cl.: G01R 33/038

(54) **Display apparatus for magnetic field**

(30) Priority: 05.12.1995 JP 316435/95
(71) Applicant: MITSUBISHI DENKI KABUSHIKI KAISHA, Tokyo 100 (JP)
(72) Inventor: Shimohata, Kenji, Chiyoda-ku, Tokyo 100 (JP); Ohara, Akinori, Chiyoda-ku, Tokyo 100 (JP); Akagi, Hidenari, Chiyoda-ku, Tokyo 100 (JP); Amano, Toshiyuki, Chiyoda-ku, Tokyo 100 (JP); Karino, Seiji, Chiyoda-ku, Tokyo 100 (JP); Fujimoto, Yasushi, Chiyoda-ku, Tokyo 100 (JP); Seo, Kazutaka, Chiyoda-ku, Tokyo 100 (JP); Nagao, Masashi, Chiyoda-ku, Tokyo 100 (JP); Morita, Masao, Chiyoda-ku, Tokyo 100 (JP); Hyun, Kim Tae, Chiyoda-ku, Tokyo 100 (JP); Matsuda, Tetsuya, Chiyoda-ku, Tokyo 100 (JP)
(74) Representative: Ritter und Edler von Fischern, Bernhard, Dipl.-Ing.

(57) **Abstract**

A moving member such as an iron sphere made of a magnetic material is contained in a case, and it can move in the case by an external magnetic field. The moving member is moved between a position adjacent to a window of the case and another distant position. Further, the magnetic field is displayed by using the movement of the iron sphere. For example, a word, a sign, a picture or a color for warning the existence of magnetic field is displayed according to the movement of the iron sphere. The moving member can be moved by a magnetic force against the gravity or a spring force. The moving member may be moved with a rotation mechanism around a rotational axis. A modified apparatus comprises a case changing its volume by the movement of the moving member and a display section communicated to the case and having a liquid contained therein. The existence of magnetic field is shown by the existence of the liquid in the display section.

## Description

### BACKGROUND OF THE INVENTION

### Field of the Invention

The present invention relates to an apparatus for displaying magnetic field generated by a magnet such as a superconducting magnet.

### Description of the Prior Art

Apparatuses for displaying generation of magnetic field are used for example for warning generation of magnetic field in many machines such as a magnetic levitation train, a magnetic resonance imaging apparatus, a nuclear fusion magnet, a dynamo, an accelerator, a crystal pulling apparatus and the like. An apparatus described in Japanese patent laid open publication 68881/1991 uses a Hall element to detect magnetic field. This apparatus needs an electric power source. If an electric cell is used, the life thereof is short, while if a cell of a large capacity is used, the apparatus becomes heavy. If a commercial AC power source is used, it becomes difficult to move the apparatus. Further, it cannot be used when power failure occurs. It is also a problem that the structure is complex, and the reliability is low. A detector described in German patent 2357786 has a buffer gas switch connected between batteries and an optical or acoustic display device. The display device warns magnetic field when the switch is closed by a magnetic field. This apparatus also needs an electric power source.

Apparatuses with no electric power source are also known. For example, an apparatus described in Japanese Utility Model laid open Publication 2813/1980 has a bar magnet to detect a remnant magnetic field of a lifting magnet. The bar magnet is set to be rotatable along the remnant magnetic field, and the existence of remnant magnetic field is recognized by the rotation angle of the bar magnet. The magnet has a balance weight connected thereto to keep it at a neutral position and to set a threshold magnetic field. An apparatus described in European patent EP 0 356 787, two sensor magnets of opposite directions are enclosed in a case. At high magnetic field, the two magnets align along the same direction and are separated from each other to display the existence of magnetic field. The invention intends to provide a new type of such an apparatus with no electric power source.

### SUMMARY OF THE INVENTION

An object of the present invention is to provide an apparatus which displays magnetic field with a simple structure surely without an electric power source.

In one aspect of the invention, an apparatus for displaying magnetic field comprises a case having a window and a moving member contained in the case and comprises a magnetic material. The moving member such as a magnetic sphere or a magnetic plate is moved by external magnetic field between a first position adjacent to the window and a second position different from the first position. Further, a means for displaying magnetic field uses the movement of the moving member to display the magnetic field in various ways by using the position of the moving member, a word, a sign, a picture, a color or the like. For example, the moving member is moved along the window of the case according to the magnitude of magnetic field. Thus, the magnetic field is displayed by the position of the moving member. Alternatively, a word or phrase for warning magnetic field, a sign, a color or the like is arranged at a position hidden by the moving member when no magnetic field is generated. Thus, it is determined by the word or the like observed accompanied by the movement of the moving member whether magnetic field is generated or not. Alternately, the moving member itself may have a color different from the background, and when the moving member is moved to a cover or appears from the cover in magnetic field, the movement of the moving member due to the magnetic field is detected easily. The display means may also display the direction of magnetic field according the direction of the shift of the magnetic member.

Preferably, the moving member is moved in the case by a magnetic force exerting against the gravity. When magnetic field is applied, the moving member moves up against gravity. For example, the display means has a cover at the first or second position or shows different colors at the first and second positions. In a different way, the display means comprises a word, a sign, a picture, a color or the like which is shielded by the moving member at the first or second position.

Preferably, the apparatus further comprises a spring member connected between the moving member and the case, and the spring member has a force exerting to the moving member against a magnetic force of the magnetic field. Thus, the moving member is moved between the first and second positions when magnetic field is applied. The display means displays magnetic field according to the movement of the moving member as described above.

Preferably, the apparatus further comprises a rotation mechanism in the case to rotate the moving member around a rotation axis. When magnetic field is not applied, the moving member extends downward due to gravity, while when magnetic field is applied, the moving member is moved by the rotation mechanism. Thus, the moving member is moved between the first and second positions. The display means displays magnetic field by using the movement of the moving member. For example, the rotation mechanism itself is covered with a color layer which is observed only at the first or second position. In a different way, the display means comprises a word, a sign, a picture, a color or the like which is shielded by the moving member at the first or second position.

Preferably, the apparatus comprises a plurality of moving members each having a rotation mechanism. The moving member is arranged at the front of the apparatus. When magnetic field is applied, the moving members are moved by the rotation mechanisms to disclose the inside of the case. The display means uses the rotation to display magnetic field.

Preferably, the moving member is arranged to move between the first and second positions along the window of the case. The moving member moves vertically according to the relationship between the gravity and magnetic force, horizontally according to the relationship between the spring force and the magnetic force, or in two dimensions according to the relationship between the gravity, the spring force and the magnetic force.

Preferably, the case has a slope inclined from a horizontal direction, the moving member movable on the slope in magnetic field. The slope may be upward or downward from the front to the back of the case. The moving member moves along the slope. The slope may change at two steps.

Preferably, the display means displays magnetic field with a character, a sign, a picture or a color as described above. For example, the display means comprises a character or the like written on the moving member which can be observed through the window of the case. In a different way, a colored liquid is contained in the case. When magnetic field is applied, the magnetic member is removed from around the window to allow the colored liquid to enter a space around the window. Thus, the generation of magnetic field is observed by the change in color through the window.

In a second aspect of the invention, an apparatus for displaying magnetic field comprises a plurality of the apparatuses described above, so that the windows of the cases are arranged in a plane. Preferably, a plurality of moving members are contained in specified cases, so that the arrangement of the cases having the moving members display a character, a word, a sign, a picture or the like. In a different way, the colors of the cases are determined to display a character, a word, a sign, a picture or the like.

In a third aspect of the invention, a device for displaying magnetic field comprises a moving member moved by magnetic field, a case having a volume changing according to movement of the moving member, a display device connected to the case, a liquid member contained in an inner space of the case and an inner space of the display device connected to each other. The moving member is moved by magnetic field to change the volume of the case. Then, the liquid member is moved toward the display device. Thus, the display device display magnetic field according to volume change of the case.

Preferably, the means for displaying magnetic field displays magnetic field with a character, a sign, a picture or a color as described above. For example, the display device shows a phrase of warning. In a different way, the display device shows a different color when magnetic field is generated.

An advantage of the present invention is that the existence of magnetic field can be displayed with a simple structure.

Another advantage of the invention is that an apparatus can be provided with which generation of magnetic field can be observed at a desired direction.

A still another advantage of the invention is that the magnitude of magnetic field is shown by using different slopes of the apparatus.

A further advantage of the invention is that an apparatus having a large display area is provided.

A still further advantage of the invention is that the existence of magnetic field can be displayed at a position distant from the magnetic field.

### BRIEF DESCRIPTION OF THE DRAWINGS

These and other objects and features of the present invention will become clear from the following description taken in conjunction with the preferred embodiments thereof with reference to the accompanying drawings, and in which:
Fig. 1A is a front view of an apparatus according to a first embodiment under no magnetic field, Fig. 1B is a sectional side view thereof under no magnetic field, and Fig. 1C is a front view thereof under magnetic field;
Fig. 2A is a front view of an apparatus according to a second embodiment under no magnetic field, Fig. 2B is a sectional side view thereof under no magnetic field, and Fig. 2C is a front view thereof under magnetic field;
Fig. 3A is a front view of an apparatus according to a third embodiment under no magnetic field, Fig. 3B is a sectional side view thereof under no magnetic field, and Fig. 3C is a front view thereof under magnetic field;
Fig. 4A is a front view of an apparatus according to a fourth embodiment under no magnetic field, and Fig. 4B is a front view thereof under magnetic field;
Fig. 5A is a front view of an apparatus according to a fifth embodiment under no magnetic field, Fig. 5B is a front view thereof under downward magnetic field, and Fig. 5C is a front view thereof under upward magnetic field;
Fig. 6A is a front view of an apparatus according to a sixth embodiment under no magnetic field, Fig. 6B is a sectional side view thereof under no magnetic field, and Fig. 6C is a front view thereof under magnetic field;
Fig. 7A is a front view of an apparatus according to a seventh embodiment under no magnetic field, Fig. 7B is a sectional side view thereof under no magnetic field, Fig. 7C is a front view thereof under magnetic field, and Fig. 7D is a sectional side view thereof under magnetic field;
Fig. 8A is a perspective view of an apparatus according to an eighth embodiment under no magnetic field, and Fig. 8B is a perspective view thereof under magnetic field;
Fig. 9A is a perspective view of an apparatus according to a ninth embodiment under no magnetic field, and Fig. 9B is a perspective view thereof under magnetic field;
Fig. 10A is a front view of an apparatus according to a tenth embodiment under no magnetic field, Fig. 10B is a sectional side view thereof under no magnetic field, Fig. 10C is a front view thereof under magnetic field, and Fig. 10D is a sectional side view thereof under magnetic field;
Fig. 11A is a top plan view of an apparatus according to an eleventh embodiment under no magnetic field, Fig. 11B is a sectional front view thereof under no magnetic field, Fig. 11C is a top plan view thereof under magnetic field, and Fig. 11D is a sectional front view thereof under magnetic field;
Fig. 12A is a top plan view of an apparatus according to a twelfth embodiment under no magnetic field, Fig. 12B is a sectional front view thereof under no magnetic field, Fig. 12C is a top plan view thereof under weak magnetic field, Fig. 12D is a sectional front view thereof under weak magnetic field, Fig. 12E is a top plan view thereof under strong magnetic field, and Fig. 12F is a sectional front view thereof under strong magnetic field;
Fig. 13A is a front view of an apparatus according to a thirteenth embodiment under no magnetic field, Fig. 13B is a sectional side view thereof under no magnetic field, Fig. 13C is a front view thereof under magnetic field, and Fig. 13D is a sectional side view thereof under magnetic field;
Fig. 14A is a front view of an apparatus according to a fourteenth embodiment under no magnetic field, Fig. 14B is a sectional side view thereof under no magnetic field, Fig. 14C is a front view thereof under magnetic field, and Fig. 14D is a sectional side view thereof under magnetic field;
Fig. 15A is a front view of an apparatus according to a fifteenth embodiment under no magnetic field, Fig. 15B is a sectional side view thereof under no magnetic field, Fig. 15C is a front view thereof under magnetic field, and Fig. 15D is a sectional side view thereof under magnetic field;
Fig. 16A is a front view of an apparatus according to a sixteenth embodiment under no magnetic field, Fig. 16B is a sectional side view thereof under no magnetic field, Fig. 16C is a front view thereof under magnetic field, and Fig. 16D is a sectional side view thereof under magnetic field;
Fig. 17A is a front view of an apparatus according to a seventeenth embodiment under no magnetic field, Fig. 17B is a sectional side view thereof under no magnetic field, Fig. 17C is a front view thereof under magnetic field, and Fig. 17D is a sectional side view thereof under magnetic field;
Fig. 18A is a front view of an apparatus according to an eighteenth embodiment under no magnetic field, Fig. 18B is a sectional side view thereof under no magnetic field, Fig. 18C is a front view thereof under magnetic field, and Fig. 18D is a sectional side view thereof under magnetic field;
Fig. 19A is a sectional view of an apparatus according to a nineteenth embodiment under no magnetic field, and Fig. 19B is a sectional view thereof under magnetic field;
Fig. 20A is a sectional view of an apparatus according to a twentieth embodiment under no magnetic field, and Fig. 20B is a sectional view thereof under magnetic field;
Fig. 21A is a vertical sectional view of a superconducting magnet with devices for detecting magnetic field, and Fig. 21B is a sectional view thereof;
Fig. 22A is a vertical sectional view of a superconducting magnet with devices for detecting magnetic field, and Fig. 22B is a sectional view thereof;
Fig. 23A is a vertical sectional view of a superconducting magnet with devices for detecting magnetic field, and Fig. 23B is a sectional view thereof; and
Fig. 24A is a vertical sectional view of a superconducting magnet with devices for detecting magnetic field, and Fig. 24B is a sectional view thereof.

### DETAILED DESCRIPTION OF THE PREFERRED EMBODIMENTS

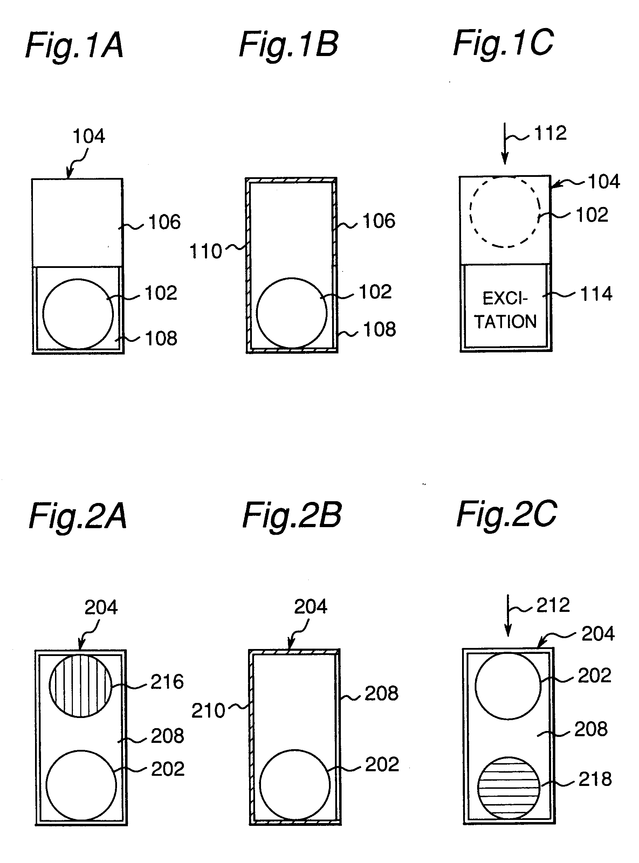

Referring now to the drawings, wherein like reference characters designate like or corresponding parts throughout the views, Figs. 1A - 1C show a magnetic field display apparatus for displaying magnetic field according to a first embodiment of the invention. Fig. 1A is a front view of the apparatus under no magnetic field, Fig. 1B is a sectional side view thereof under no magnetic field, and Fig. 1C is a front view of the apparatus under magnetic field. The direction of gravity is from above to below in these drawings. This holds also for other drawings. In the apparatus shown in Figs. 1A - 1C, a moving member 102, or an iron ball in this example, made of a magnetic material is contained in a case 104 of rectangular parallelepiped. The case 104 is set so that its longitudinal direction is vertical. The case 104 has an upper opaque cover 106 and a lower transparent cover 108 at the front side and a back plate 110 at the back side. An arrow for illustrating the magnetic field 112 means a direction of magnetic flux density. A word 114 of "EXCITATION" for warning is written on the lower front of the back plate 110.

Next, the operation of the magnetic field display apparatus is explained. As shown in Figs. 1A and 1B, the moving member 102 is located at the bottom of the case 104. In this case, the word 114 of "EXCITATION" is not observed from the front side. On the other hand, as shown in Fig. 1C, when a magnetic field 112 is applied, the moving member 102 moves to the top of the case 104 and disappears if the magnetic force which tends to move the moving member 102 upward is larger than the gravity force. Then, the word 114 of "EXCITATION" is observed at the lower side of the case 104. Thus, a man can recognize whether magnetic field is generated or not.

Though the word 114 of "EXCITATION" is shown in this example, other words such as "DANGER", "MAGNETIC FIELD UNDER GENERATION" or "B" may be used for informing that magnetic field is generated. Alternately, a picture or a signal may be used. Alternately, the existence of magnetic field can be shown with a color. For example, the moving member 102 is blue and the word 114 or the bottom of the case 104 is yellow.

In the above example, the moving member 102 has a shape of a sphere. However, the moving member 102 may be a cube, a plate or the like other than a sphere. In the above example, the moving member 102 is made of iron. However, the moving member 102 may be made of a magnetic material other than iron such as a permanent magnet or a ferromagnet. The moving member may be made from a magnetic material partially. The above-mentioned modifications may hold also for the embodiments explained below.

Fig. 2A is a front view of a magnetic field display apparatus according to a second embodiment under no magnetic field, Fig. 2B is a sectional side view thereof under no magnetic field, and Fig. 2C is a front view of the apparatus under magnetic field. A moving member 202, or an iron ball in this example, made of a magnetic material is contained in a case 204 of rectangular parallelepiped. The case 204 is set so that its longitudinal direction is vertical. The case 204 has a transparent cover 208 at the front side and a back plate 210 at the back side. The transparent cover 208 covers the window of the case 204. As shown in Figs. 2A and 2C, a blue display 216 and a red display 218 are provided at the upper front side and at the lower front side of the back plate 210.

Next, the operation of the magnetic field display apparatus is explained. As shown in Figs. 2A and 2B, the moving member 202 lies at the bottom of the case 204 when no magnetic field is applied to the moving member 102. Then, the red display 218 is shielded by the moving member 102, and a user observes only the blue display 216 at the upper side. On the other hand, as shown in Fig. 2C, when a magnetic field 212 is applied, the moving member 202 moves to the top of the case 204 if the magnetic force which tends to move the moving member 202 upward is larger than the gravity. Thus, the blue display 216 is shielded by the moving member 202, while the red display 218 appears at the lower side. Thus, a man can recognize from the color whether magnetic field is generated or not.

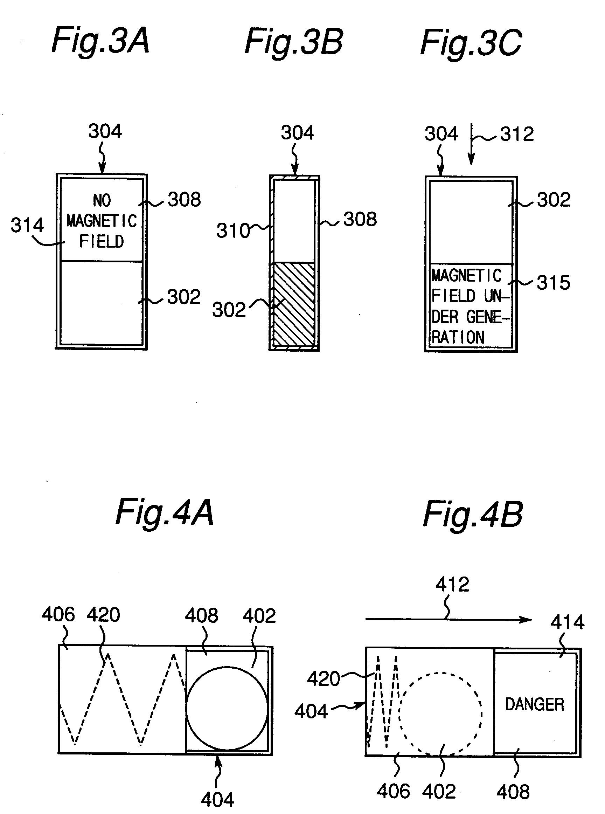

Fig. 3A is a front view of a magnetic field display apparatus according to a third embodiment under no magnetic field, Fig. 3B is a sectional side view thereof under no magnetic field, and Fig. 3C is a front view of the apparatus under magnetic field. In Figs. 3A - 3C, a moving member 302 made of an iron plate is used instead of the iron sphere used in the above embodiments. The moving member 302 is contained in a case 304 of rectangular parallelepiped. The case 304 is set so that its longitudinal direction is vertical. The case 304 has a transparent cover 308 at the front side and a back plate 310 at the back side. The transparent cover 308 covers the window of the case 304. The moving member 302 has a size which fills a half of the inside of the case 304. Further, a phrase 314 of "NO MAGNETIC FIELD" is written on the upper front of the back plate 310, and another phrase 315 of "MAGNETIC FIELD UNDER GENERATION" is written on the lower front of the back plate 310, as shown in Figs. 3A and 3C.

Next, the operation of the magnetic field display apparatus is explained. As shown in Figs. 3A and 3B, the moving member 302 is located at the bottom of the case 304. In this case, the phrase 314 of "NO MAGNETIC FIELD" is observed at the upper side, while the other phrase 315 of "MAGNETIC FIELD UNDER GENERATION" is shielded by the moving member 302. On the other hand, as shown in Fig. 3C, when a magnetic field 312 is applied, the moving member 302 moves to the top of the case 304 if the magnetic force which tends to move the moving member 302 upward is larger than the gravity. Then, the phrase 315 of "MAGNETIC FIELD UNDER GENERATION" is observed, while the other 314 of "NO MAGNETIC FIELD" is shielded by the moving member 302. Thus, by observing the phrase 315, a man can recognize that the magnetic field is under generation.

Further, if the phrase 314 of "NO MAGNETIC FIELD" is written with red and the phrase 315 of "MAGNETIC FIELD UNDER GENERATION" is written with blue, even a person such as an infant or a foreigner can recognize the danger.

Fig. 4A is a front view of a magnetic field display apparatus according to a fourth embodiment under no magnetic field, and Fig. 1B is a front view of the apparatus under magnetic field. A moving member 402, or an iron ball in this example, made of a magnetic material is contained in a case 404 of rectangular parallelepiped. The case 404 is set so that its longitudinal direction is horizontal. The case 404 has an left opaque cover 406 and a right transparent cover 408 at the front side and a back plate at the back side. A spring 420 is installed to connect the left side of the case 404 and the moving member 402 so as to push the moving member 402 rightward. Then, as shown in Fig. 4A, the moving member 402 is observed through the transparent cover 408. A word 414 of "DANGER" is written on the right front of the back plate as shown in Fig. 4B. In this embodiment, the moving member 402 is moved according to a relationship between a spring force of the spring 420 and a magnetic force of the moving member 402 according to an external horizontal magnetic field 412.

Next, the operation of the magnetic field display apparatus is explained. As shown in Fig. 4A, the moving member 402 is located at the right in the case 404 by the spring force when there is no magnetic field. In this case, the word 414 of "DANGER" is shielded by the moving member 402 and not observed from the front side. On the other hand, as shown in Fig. 4B, when the magnetic field 412 is applied horizontally, the moving member 402 moves to the left and disappears if the magnetic force which tends to move the moving member 402 leftward is larger than the spring force. Then, the word 414 of "DANGER" is observed at the right side. Thus, a man can recognize that the magnetic field is under generation.

If the magnetic force is weak, the moving member 402 is stopped at a position where the magnetic force is balanced with the spring force. It is preferable that the right half of the back plate covered by the transparent cover 408 is yellow and the left half thereof is red. Then, when the magnetic field 412 is weak, only yellow is observed, while when the magnetic field 412 is strong, both yellow and red are observed. Then, the magnitude of the magnetic field can be recognized by the colors.

In the example shown in Figs. 4A - 4C, the transparent cover 408 is provided at the right side of the case 404. On the other hand, if the transparent cover 408 is provided at the left side of the case 404, a magnetic field of reverse direction. In a different example, the case 404 has a larger volume and the transparent cover 408 is provided at the upper or lower side. Then, the position of the moving member 402 is determined by the relation between the gravity, the spring force and the magnetic force in two dimensions. Then, the magnetic field along gravity direction or along its reverse direction can also be detected.

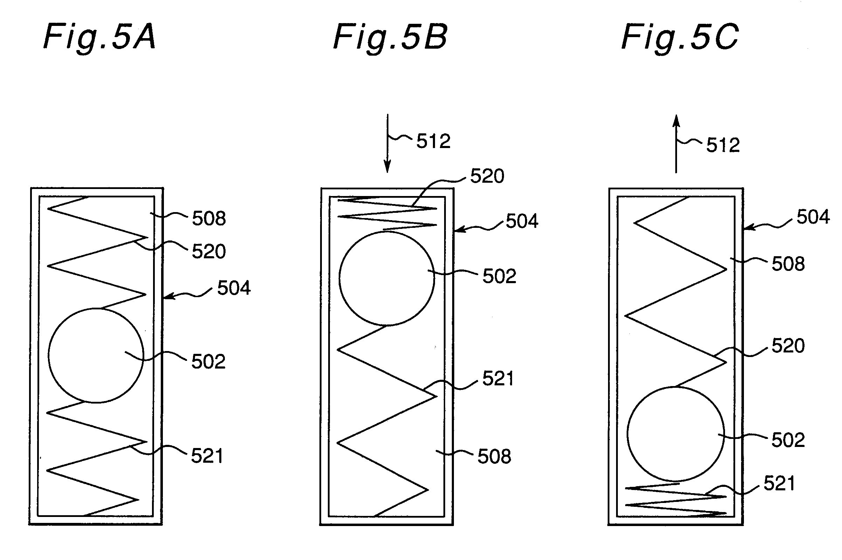

Fig. 5A is a front view of a magnetic field display apparatus according to a fifth embodiment under no magnetic field, Fig. 5B is a front view thereof under downward magnetic field, and Fig. 3C is a front view thereof under upward magnetic field. A moving member 502, or an iron ball in this example, made of a magnetic material is contained in a case 504 of rectangular parallelepiped. The case 504 is set so that its longitudinal direction is vertical. The case 504 has a transparent cover 508 at the front side and a back plate at the back side. Two spring members 520 and 512 are provided in the case 504 to connect the top side of the case 504 and the moving member 502 and to connect the bottom side of the case 504 and the moving member 502. Thus, the moving member 502 is supported by the two springs 520 and 521. As shown in Fig. 5A, the position of the moving member 502 is observed through the transparent cover 508. In this embodiment, the moving member 502 made of a spherical iron is supported by the two springs 520 and 521. The moving member 502 has N pole at the top side and S pole at the bottom. As shown in Fig. 5A, when no magnetic field is applied, the moving member 502 is located at the center of the case 504. As shown in Figs. 5B and 5C, the moving member 502 moves upward or downward according to the relation between the spring force, the gravity and the magnetic force of the magnetic field 512. Then, the existence of magnetic field and the direction thereof, if any, can be displayed according to the position of the moving member 502.

In the example shown in Figs. 5A - 5C, the moving member 502 is moved upward and downward. However, it may be modified so that the moving member 502 is moved to the right and left. Then, the magnetic field along the horizontal direction can be recognized.

Further, the spherical moving member 502 is not necessarily made only of a magnet. Magnet pieces may be embedded only at positions fixed to the springs 520 and 521 in the moving member 502. The shape of the moving member 502 is not limited to a sphere.

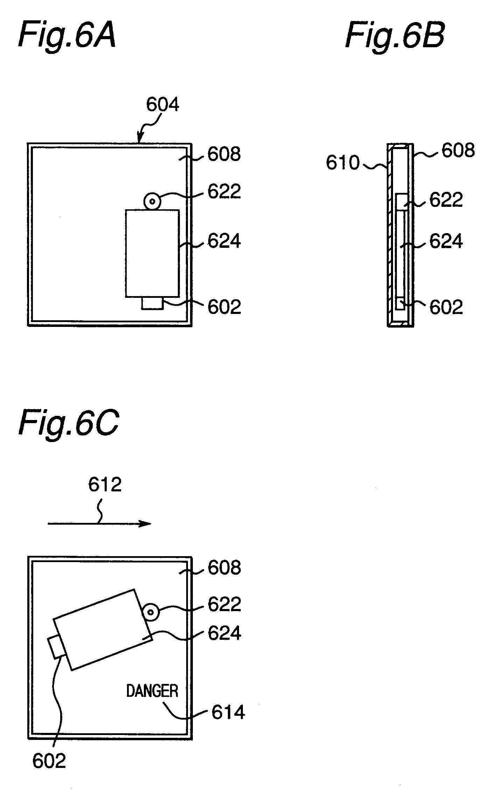

Fig. 6A is a front view of a magnetic field display apparatus according to a sixth embodiment under no magnetic field, Fig. 6B is a sectional side view thereof under no magnetic field, and Fig. 6C is a front view thereof under magnetic field. In this embodiment, as shown in Fig. 6A, a moving member is contained in a case 604 of rectangular parallelepiped, and the moving member is rotatable by magnetic field around a rotation axis 622. The moving member consists of a plate 624 made of a plastics material which is connected to the axis 622 at one end and an iron plate 602 attached to the opposite end of the plate 624. The axis 622 is fixed to a transparent cover 608 of the case 604, as shown in Fig. 6B. A word 614 of "DANGER" is written on the inside of a back plate 610 of the case 604 as shown in Fig. 6C.

Next, the operation of the magnetic field display apparatus is explained. When no magnetic field is applied, the plate 624 hangs down from the axis 622 due to the gravity, and the word 614 of "DANGER" is hidden by the plate 624. As shown in Fig. 6C, when magnetic field 612 is applied in a horizontal direction, the plate 624 is rotated to the direction of the magnetic field 612 which is exerted on the iron plate 602, and the word 614 of "DANGER" appears. Then, the existence of the magnetic field can be recognized by the word 614 for warning.

In the example shown in Figs. 6A - 6C, the axis 622 is provided at the right side of the case 604, and the plate 624 is rotated leftward when magnetic field is applied. On the other hand, if the axis 622 is provided at the center of the case 604, the plate 624 and the iron plate 602 are allowed to move right and left. Then, magnetic field along the right and left directions can be detected and displayed.

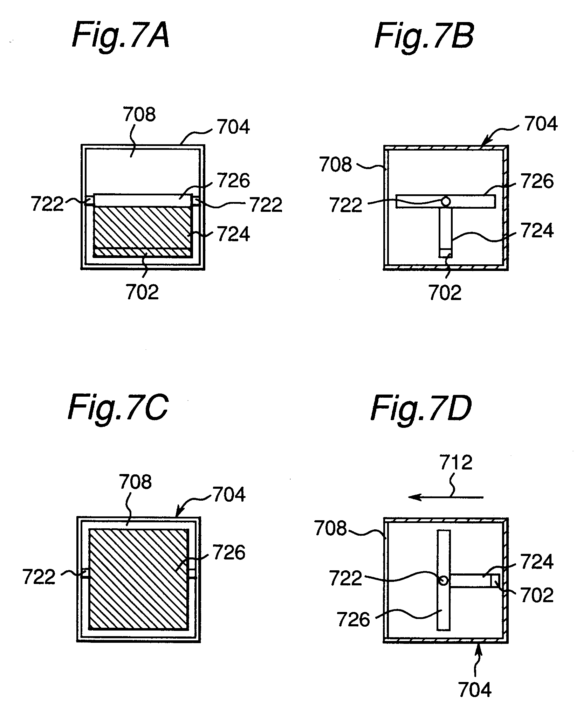

Fig. 7A is a front view of a magnetic field display apparatus according to a seventh embodiment under no magnetic field, Fig. 7B is a sectional side view thereof under no magnetic field, Fig. 7C is a front view thereof under magnetic field, and Fig. 7D is a sectional side view thereof under magnetic field. An axis 722 is fixed in a case 704 at two ends thereof as shown in Fig. 7A, while it is also fixed to a red rectangular plate 726 at its center as shown in Fig. 7B. Further, a blue rectangular plate 724 is adhered to the red plate 726 near the axis 722 to form a right angle. A magnetic bar 702, for example an iron bar, is adhered to the top of the blue plate 724. The case 704 of rectangular parallelepiped has a transparent cover 708 at the front.

Next, the operation of the magnetic field display apparatus is explained. When no magnetic field is applied, the blue plate 724 hangs down from the axis 722 due to the gravity, and the blue color can be observed at the front. As shown in Fig. 7C, when magnetic field 712 is applied along the horizontal direction, the magnetic force is exerted on the magnetic bar 702 to the direction of the magnetic field 712, to rotate the plates 724 and 726, as shown in Fig. 7D. Then, as shown in Fig. 7C, the red plate 726 is observed at the whole front. Usually, blue means safe and red means danger. Then, the existence of the magnetic field can be recognized by observing the red color.

If the back surface of the red plate 726 has a different color, magnetic field having a direction reverse to the magnetic field 712 can also be displayed and recognized.

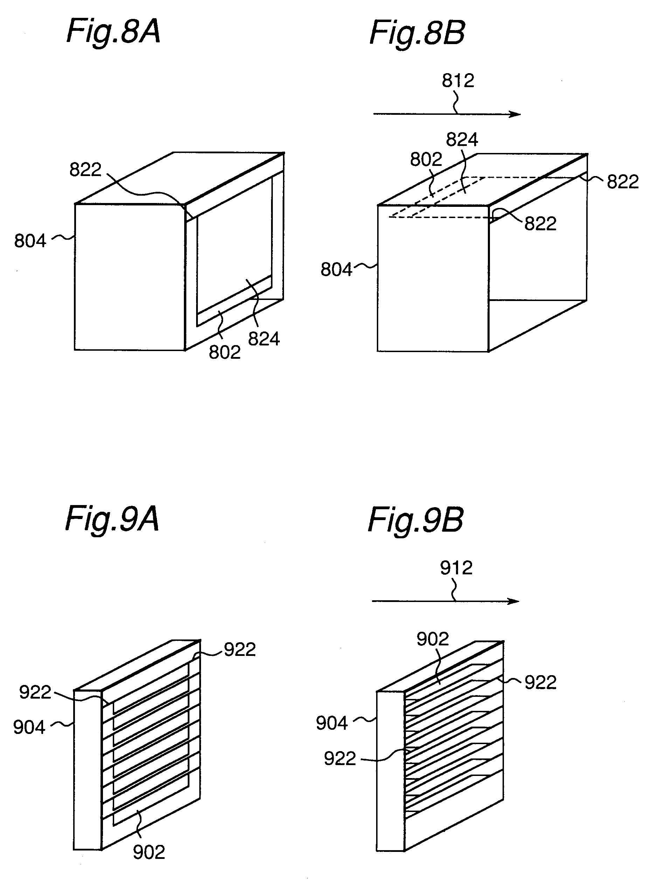

Fig. 8A is a perspective view of a magnetic field display apparatus according to an eighth embodiment under no magnetic field, and Fig. 8B is a perspective view thereof under magnetic field. A moving member 802, 824 is provided at the front of a case 804 of rectangular parallelepiped. An axis 822 is provided near the top of the case 804 at the front thereof. An end of a blue rectangular plate 824 is connected to be rotatable around the axis 822, and the other the other end thereof is connected to a magnetic bar 802. Further, the inside of the case 804 is red.

Next, the operation of the magnetic field display apparatus is explained. When no magnetic field is applied, the blue plate 824 hangs down from the axis 822 due to the gravity, as shown in Fig. 8A, and the blue color is observed at the front. As shown in Fig. 8B, when magnetic field 812 is applied, the magnetic force is exerted on the magnetic bar 802 to the direction of the magnetic field 812, to rotate the plate 824, as shown in Fig. 8B. Then, the red color of the case 804 is observed at the front. Usually, blue means safe and red means danger. Then, the existence of the magnetic field can be recognized by observing the red color.

If the axis 822 is set so that the plate 824 can be rotated forward, magnetic field having a direction reverse to the magnetic field 812 can also be displayed and recognized.

Fig. 9A is a perspective view of a magnetic field display apparatus according to a ninth embodiment under no magnetic field, and Fig. 9B is a perspective view thereof under magnetic field. In this embodiment, a plurality of rectangular magnetic plates 902 is arranged at the front of a case 904 of rectangular parallelepiped from the top to the bottom. Each magnetic plate 902 is connected to be rotatable around the axis 922. The magnetic plates 902 are blue with a blue paint or the like. Further, a red phrase of "MAGNETIC FIELD UNDER GENERATION" (not shown) is written on the inside of the back plate of the case 904.

Next, the operation of the magnetic field display apparatus is explained. When no magnetic field is applied, the blue magnetic plates 902 hang down from the axes 922 due to the gravity, as shown in Fig. 9A, and the blue color can be observed at the front. As shown in Fig. 9B, when magnetic field 912 is applied along a horizontal direction, the magnetic force is exerted on the magnetic bars 902 to the direction of the magnetic field 912, to rotate the plates 902, as shown in Fig. 9B. Then, the red phrase is observed at the front, and the existence of the magnetic field can be recognized by observing the warning phrase.

In this embodiment, eight moving members are used instead of a single moving member used in the eighth embodiment shown in Figs. 8A and 8B. Then, the depth of the case 904 can be decreased for the same display area of blue color in contrast to the counterpart of the eighth embodiment. That is, the case 904 can be made compact.

If the axes 922 are set so that the plates 902 can be rotated forward, magnetic field having a direction reverse to the magnetic field 912 can also be displayed and recognized, similarly to the eighth embodiment.

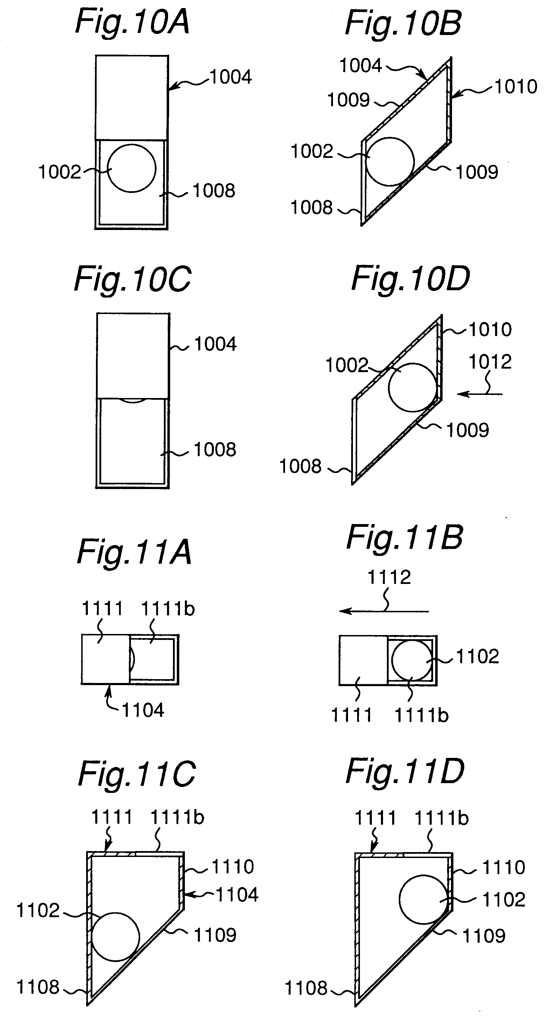

Fig. 10A is a front view of a magnetic field display apparatus according to a tenth embodiment under no magnetic field, Fig. 10B is a sectional side view thereof under no magnetic field, Fig. 10C is a front view thereof under magnetic field, and Fig. 10D is a sectional side view thereof under magnetic field. A case 1004 comprises a front vertical transparent plate 1008, bottom and top slant plates 1009, a back vertical plate 1010, and two side plates. The front plate 1008, the bottom and top slant plates 1009 and the back plate 1010 form a section of parallelogram, as shown in Figs. 10B and 10D. An iron sphere 1002 as a moving member is contained in the case 1004.

Next, the operation of the magnetic field display apparatus is explained. When no magnetic field is applied, the iron sphere 1002 contacts with the transparent front plate 1008 due to the gravity, as shown in Figs. 10A and 10B. Then, the iron sphere 1002 can be observed at the front. When horizontal magnetic field 1012 is applied, the magnetic force is exerted on the iron sphere 1002 to the direction of the magnetic field 1012, to move the iron sphere 1002 toward the back plate 1010. However, if the magnetic field 1012 is weaker than the gravity, and the iron sphere 1002 remains at the front and can be observed at the front. As the magnetic field increases, the iron sphere 1002 rises toward the back plate 1010 after the magnetic field exceeds a threshold, as shown in Figs. 10C and 10D, and the iron sphere 1002 disappears for an observer at the front. Thus, the existence of the magnetic field higher than the threshold can be recognized by observing the iron sphere 1002. The threshold depends on the weight of the iron sphere 1002, the slant angle of the slant plate 1009 and the like.

In the above example, the number of the iron sphere 1002 is one. However, a plurality of iron spheres may be contained in the case 1004, and a similar display effect can be realized.

Instead of the iron sphere 1002, a liquid dispersing magnets may be contained in the case 1004. In this case, the liquid is moved similarly according to the magnetic field.

A character, a word, a picture or the like may be written at a portion of the inside of the case 1004 which can be observed from the front to show the generation of magnetic field.

Fig. 11A is a top plan view of a magnetic field display apparatus according to an eleventh embodiment under no magnetic field, Fig. 11B is a sectional front view thereof under no magnetic field, Fig. 11C is a top plan view thereof under magnetic field, and Fig. 11D is a sectional front view thereof under magnetic field. A case 1104 comprises a front plate 1108, a bottom slant plate 1109, a top plate 1111, a back plate 1110, and two side plates. The front vertical plate 1108, the bottom and top plates 1109, 1111 and the back vertical plate 1010 form a quadrilateral section, as shown in Figs. 11B and 11D. The case 1104 is different from the case 1004 of the tenth embodiment in that the top plate 1111 is horizontal and that a half 1111b thereof at the back side is transparent. An iron sphere 1102 as a moving member is contained in the case 1104. A man observes the iron sphere 1102 through the transparent plate 1111b from above.

Next, the operation of the magnetic field display apparatus is explained. When no magnetic field is applied, the iron sphere 1102 contacts with the front plate 1108 due to the gravity, as shown in Fig. 11B, and it cannot be observed. When horizontal magnetic field 1112 is applied, if the magnetic field 1112 is weaker than the gravity, the iron sphere 1102 remains at the bottom and cannot be observed. As the magnetic field increases, the iron sphere 1102 rises toward the back plate 1110. If the magnetic field is sufficiently strong, the iron sphere 1102 rises to the back plate 1110, as shown in Figs. 11C and 11D, and the iron sphere 1102 is observed through the top transparent plate 1111b. Thus, the existence of the magnetic field higher than a threshold can be recognized by observing the iron sphere 1102. The threshold depends on the weight of the iron sphere 1102, the slant angle of the slant plate 1109 and the like.

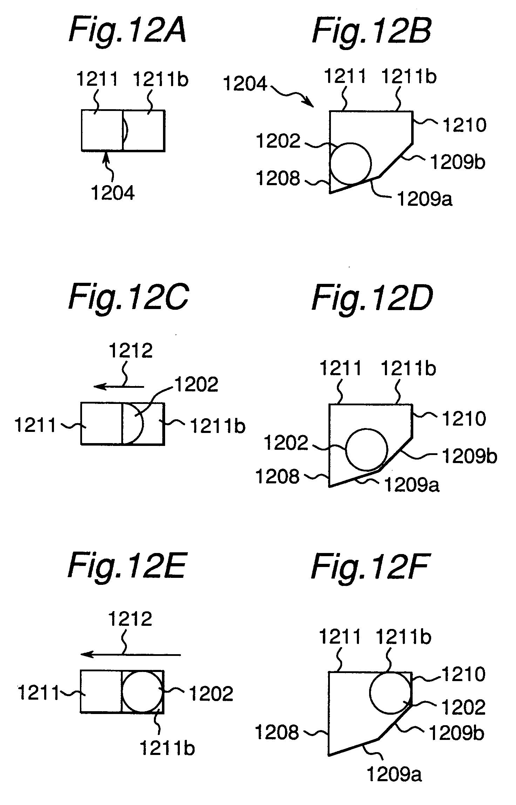

Fig. 12A is a top plan view of a magnetic field display apparatus according to a twelfth embodiment under no magnetic field, Fig. 12B is a sectional front view thereof under no magnetic field, Fig. 12C is a top plan view thereof under weak magnetic field, Fig. 12D is a sectional front view thereof under weak magnetic field, Fig. 12E is a top plan view thereof under strong magnetic field, and Fig. 12F is a sectional front view thereof under strong magnetic field. A case 1204 comprises a front plate 1208, a bottom slant plate 1209a, 1209b, a top plate 1211, a back plate 1210, and two side plates. This case 1204 is similar to the case 1202 of the eleventh embodiment except that the bottom slant plate 1209 consists of two parts 1209a, 1209b having different slopes. The 1209a part of the plate at the front side has a slope gentler than the other 1209b at the back side. An iron sphere 1202 as a moving member is contained in the case 1204. Similarly to the eleventh embodiment, the half 1209b of the horizontal top plate at the back side is transparent, and the iron sphere 1202 may be observed through the transparent plate 1211b from above.

Next, the operation of the magnetic field display apparatus is explained. When no magnetic field is applied, the iron sphere 1202 contacts with the front plate 1208 due to the gravity, as shown in Figs. 12A and 12B, and it cannot be observed. When horizontal magnetic field 1212 is applied, if the magnetic field 1212 is weaker than the gravity, the iron sphere 1202 still remains at the bottom and cannot be observed. When the magnetic field exceeds the gravity along the smaller slope, the iron sphere 1202 rises toward the boundary of the two slopes, as shown in Figs. 12C and 12D. Thus, the iron sphere 1202 can be observed by half. When the magnetic field 1212 exceeds the gravity along the larger slope, the iron sphere 1202 rises further to the back plate 1210, as shown in Figs. 12E and 12F. Thus, the whole iron sphere 1202 can be observed. Thus, the magnetic field can be displayed at two stages. The two thresholds of magnetic field depend on the weight of the iron sphere 1, the slant angles of the plate 1209a, 1209b and the like.

In the example shown in Figs. 12A - 12F, the iron sphere 1202 is observed from above. However, it may also be observed from the front if a half of the front plate 1208 is made of a transparent material.

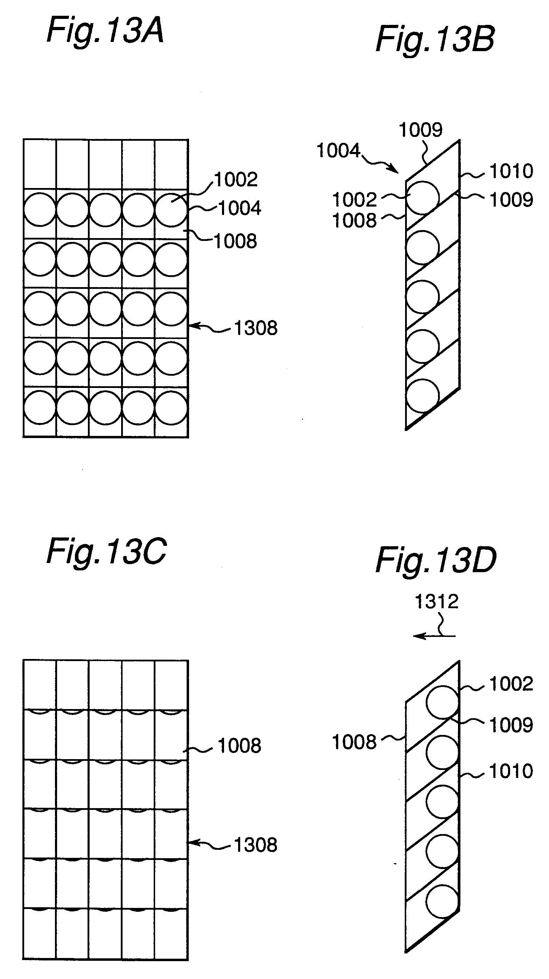

Fig. 13A is a front view of a magnetic field display apparatus according to a thirteenth embodiment under no magnetic field, Fig. 13B is a sectional side view thereof under no magnetic field, Fig. 13C is a front view thereof under magnetic field, and Fig. 13D is a sectional side view thereof under magnetic field. This apparatus corresponds to a combination of five arrays and five columns of the cases 1004 of the tenth embodiment shown in Figs. 10A - 10D, so that the front transparent plates 1008 thereof or windows are arranged at the same front plane 1308. The operation of the apparatus is similar to the counterpart of the tenth embodiment. When no magnetic field is applied, the iron spheres 1002 are observed as shown in Figs. 13A and 13B, while when sufficient horizontal magnetic field 1312 is applied, they are not observed as shown in Figs. 13C and 13D. Because the generation of magnetic field is displayed in a wider area, the existence of magnetic field can be recognized easily. Needless to say, the cases may be integrated as one body.

In the example shown in Figs. 13A - 13D, the iron spheres 1002 are observed from the front. However, if the apparatus is rotated by 90°, the iron spheres 1002 may be observed from above. Further, the cases 1004 of the tenth embodiment may be arranged in various ways, such as they can be observes in various surfaces such as "L", □, or ⊐. The slope of the bottom slant plate 1009 may have a plurality of stages as in the twentieth embodiment.

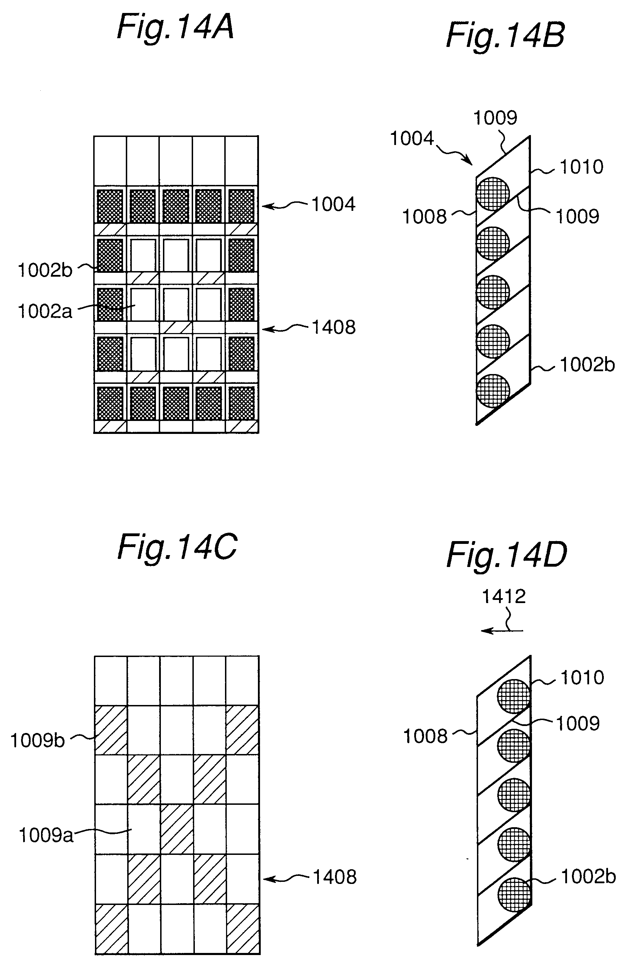

Fig. 14A is a front view of a magnetic field display apparatus according to a fourteenth embodiment under no magnetic field, Fig. 14B is a sectional side view thereof under no magnetic field, Fig. 14C is a front view thereof under magnetic field, and Fig. 14D is a sectional side view thereof under magnetic field. This apparatus is similar to the apparatus of the thirteenth embodiment in that it is a combination of five arrays and five columns of the cases 1004 of the tenth embodiment shown in Figs. 10A - 10D having slant bottom plates, so that the front transparent plates 1008 thereof or windows are arranged at the same front plane 1408. However, an iron cylinder 1002a, 1002b is contained instead of the iron sphere 1002. The iron cylinder 1002b has a different color from the iron cylinder 1002a. The iron cylinders 1002b are arranged to form a character of zero "0", as shown in Fig. 14A. Further, the bottom slant plate 1009 comprises bottom plates 1009a and 1009b having a different color at the top thereof from each other. The case 1004 having the bottom plate 1009b (illustrated with hatching) is arranged to form a sign "x", as shown in Fig. 14C. When no magnetic field is applied, the iron spheres 1009a and 1009b are observed as shown in Figs. 14A and 14B, and the character "0" is observed. When sufficient horizontal magnetic field is applied, they are not observed as shown in Figs. 14C and 14D, but the sign "x" is observed. Because the generation of magnetic field is displayed in a wider range with a character, a sign, a picture or the like, the existence of magnetic field can be recognized easily from a far position and even by a person not concerned.

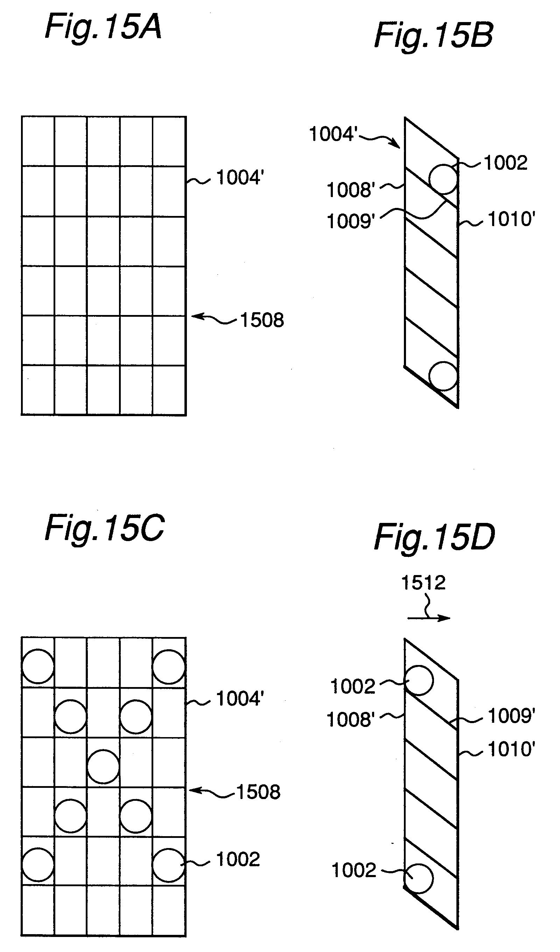

Fig. 15A is a front view of a magnetic field display apparatus according to a fifteenth embodiment under no magnetic field, Fig. 15B is a sectional side view thereof under no magnetic field, Fig. 15C is a front view thereof under magnetic field, and Fig. 15D is a sectional side view thereof under magnetic field. This apparatus is also similar to the apparatus of the thirteenth embodiment in that it is a combination of five arrays and five columns of the cases 1004' similar to the case 1004 of the tenth embodiment shown in Figs. 10A - 10D. The case 1004' also comprises a front vertical transparent plate 1008', bottom and top slant plates 1009', a back vertical plate 1010', and two side plates, and the front plate 1008', the bottom and top slant plates 1009' and the back plate 1010' form a section of parallelogram, as shown in Figs. 15B and 15D. The slope of the bottom plates 1009' is reverse to the counterpart of the tenth embodiment. That is, the slope is high at the front and low at the back. Thus, iron spheres 1002 in the cases 1004' are not observed at the front when no magnetic field is applied, but may be observed when magnetic field is applied. Further, the front plates 1008' thereof or windows are arranged at the same front plane 1508. However, the iron spheres 1002 as moving members are provided only at specified cases. In the example shown in Figs. 15A - 15D, the magnetic spheres 1002 are provided at nine cases for forming a sign "x" when magnetic field 1512 is applied along a horizontal direction. As shown in Fig. 15A, the sign "x" is not observed when no magnetic field is applied. Thus, the existence of magnetic field can be displayed easily.

In a modified example, the iron cylinders used in the fourteenth embodiment are used instead of the spheres 1002. Further, a sign, a character, a picture or the like other than "x" may be displayed easily by changing the positions of the iron spheres 1002.

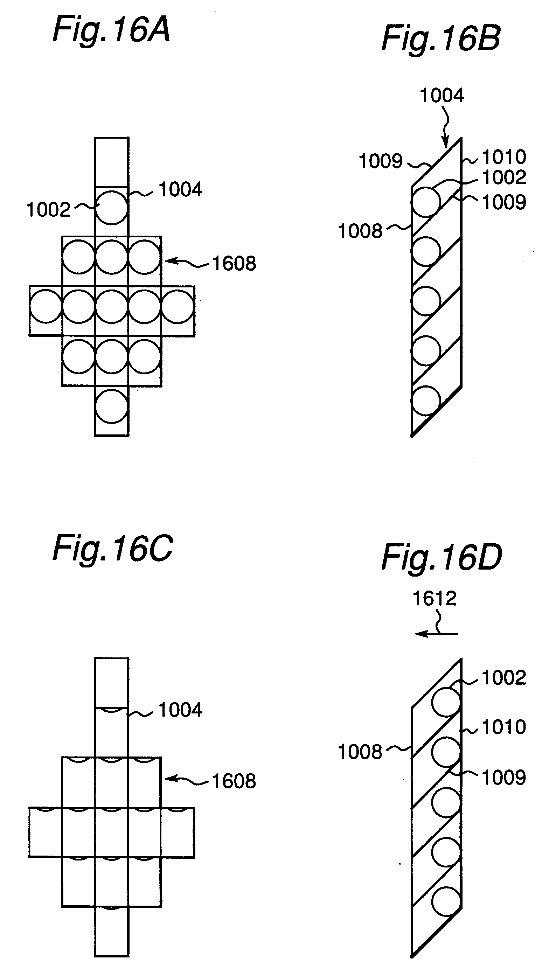

Fig. 16A is a front view of a magnetic field display apparatus according to a sixteenth embodiment under no magnetic field, Fig. 16B is a sectional side view thereof under no magnetic field, Fig. 16C is a front view thereof under magnetic field 1612, and Fig. 16D is a sectional side view thereof under magnetic field. This apparatus is also similar to the apparatus of the thirteenth embodiment in that it comprises thirteen cases 1004 of the tenth embodiment, but the cases are arranged to form a rhombus at a front face 1608 of the apparatus, as shown in Figs. 16A and 16C. The arrangement of the cases may have an arbitrary pattern such as a circle other than the rhombus.

For example, the iron spheres 1002 are green, while the inside of the case 1004 is red. Then, as shown in Fig. 16A, green spheres 1002 are observed when no magnetic field is applied, while as shown in Fig. 16C, only red is observed when a magnetic field larger than a threshold is applied. Thus, the existence of magnetic field can be recognized with colors easily.

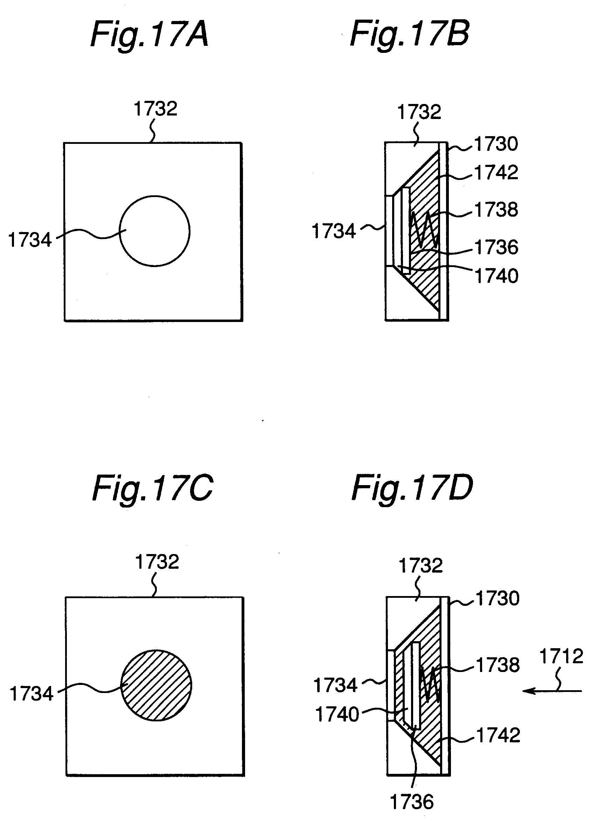

Fig. 17A is a front view of a magnetic field display apparatus according to a seventeenth embodiment under no magnetic field, Fig. 17B is a sectional side view thereof under no magnetic field, Fig. 17C is a front view thereof under magnetic field, and Fig. 17D is a sectional side view thereof under magnetic field. The apparatus comprises a base 1730 and a frame 1732 with a transparent window 1734 provided at the center of the frame 1732. Inside the case, a magnetic plate 1736 wider than the window 1734 is enclosed, and a spring 1738 fixed between the base 1730 and the magnetic plate 1736 to press the plate 1736 toward the window 1734, as shown in Fig. 17B. A white elastic plate 1740 having a shape to contact with the window 1734. As shown in Fig. 17B, red liquid 1742 (denoted with hatching) is filled in the space between the base 1730 and the plate 1736. Then, when the apparatus is observed at the front, white of the plate 1740 is observed through the window 1734, as shown in Fig. 17A, when no magnetic field is applied.

Next, the operation of the apparatus is explained. When a magnetic field 1712 is applied, a magnetic force is exerted to the magnetic plate 1736 is moved by the magnetic force against the spring force to the right side as shown in Fig. 17D. Then, the red liquid 1742 enters a space near the window 1734. Then, as shown in Fig. 17C, red is observed through the window 1734, and the existence of magnetic field can be recognized with the red color easily. As explained above, the generation of the magnetic field is displayed by moving the moving member 1736 from a first position near the window 1734 and to a second position distant from the window 1734.

The elastic plate 1740 may be omitted. Alternately, magnetic particles may be dispersed in an elastic plate. A word or the like may be written on the surface of the elastic plate 1740 or the magnetic plate 1736. Another elastic material such as rubber or teflon may be used instead of the spring 1738.

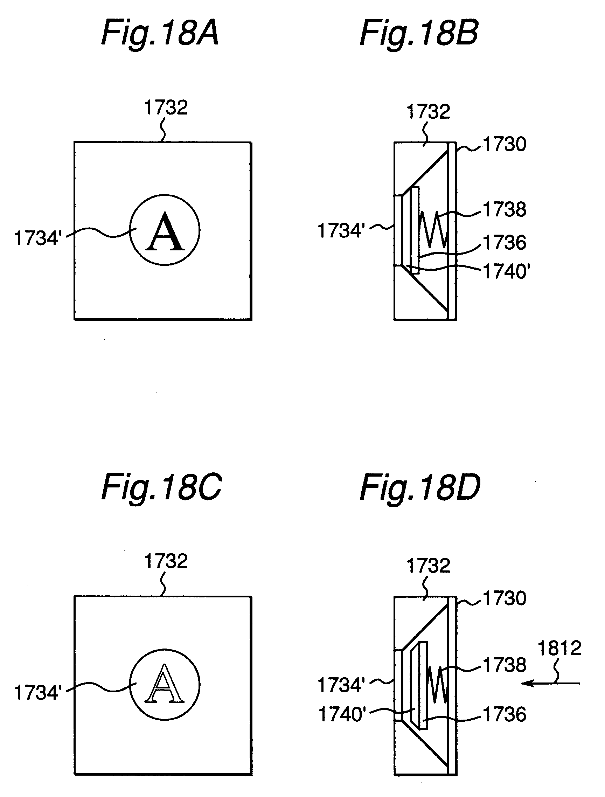

Fig. 18A is a front view of a magnetic field display apparatus according to an eighteenth embodiment under no magnetic field, Fig. 18B is a sectional side view thereof under no magnetic field, Fig. 18C is a front view thereof under magnetic field, and Fig. 18D is a sectional side view thereof under magnetic field. This apparatus is similar to that of the seventeenth embodiment. However, the red liquid is not enclosed, and the elastic plate 1740' is close to the window 1734' which is translucent. Further, a character "A" is written on the elastic plate 1740'. The character "A" may be replaced with an arbitrary character, a word, a signal, a picture or the like.

Next, the operation of the apparatus is explained. When no magnetic field is applied, the moving member 1736, 1740' is pressed to the window 1734' by the spring 1738, and the character A is observed through the window 1734'. When a magnetic field 1812 is applied, the moving member 1736, 1740' is moved to the right, as shown in Fig. 18D, and the character "A" cannot be observed or is observed vaguely through the window 1734' as shown in Fig. 18C. Thus, the existence of magnetic field can be recognized by observing the character "A".

In a modified example, liquid is included in the sealed space between the frame 1732 with the window 1734' and the base 1730.

Though the apparatuses of the seventeenth and eighteenth embodiments detect a magnetic field along the horizontal direction, a magnetic field along vertical direction may also be detected by rotating the apparatuses by 90°.

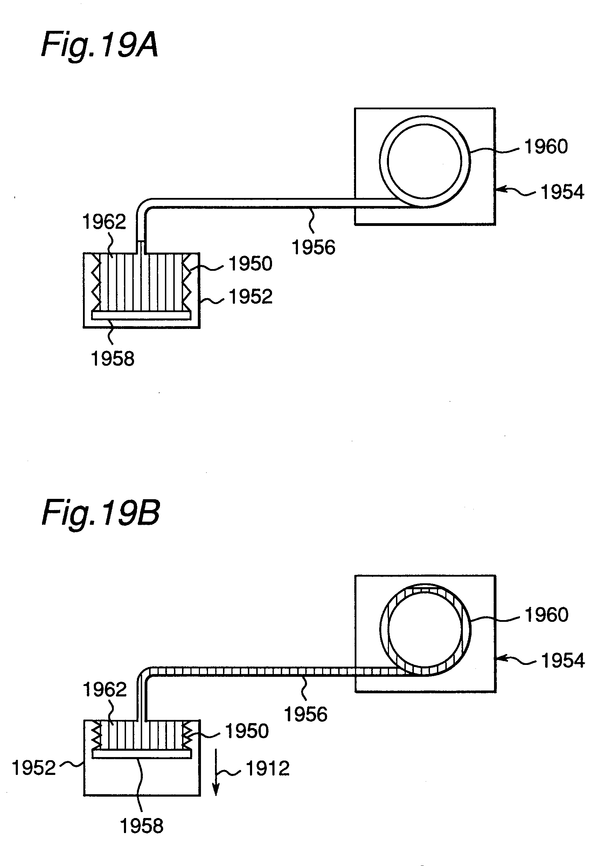

Fig. 19A is a sectional view of a magnetic field display apparatus according to a nineteenth embodiment under no magnetic field, and Fig. 19B is a sectional view thereof under magnetic field. The apparatus comprises an inner case 1950 with a variable volume provided in an outer case 1952, a display device 1954 and a tube 1956. A magnetic plate 1958 is fixed to an end of the case 1950. A circular display tube 1960 is provided in the display 1954 and the tube 1956 communicates the display tube 1954 with the inner case 1950, and a liquid 1962 is filled in the case 1950, as shown in Fig. 19A.

Next, the operation of the apparatus is explained. When no magnetic field is applied, the magnetic plate 1958 hangs down due to the gravity to expand the volume of the case 1950. Thus, the liquid exists almost in the case. On the other hand, when a magnetic field 1912 is applied, the magnetic plate 1958 moves upward to decrease the volume of the inner case 1950. Then, the liquid 1962 moves through the pipe 1956 to the display tube 1960, as shown in Fig. 19B. If the magnetic field 1912 vanishes, the volume of the case 1950 resumes the original value, and the liquid 1962 returns to the case 1950. Thus, the existence of magnetic field is displayed by the movement of liquid. A display section 1954, 1960 for displaying the existence of magnetic field can be set at a position far from a detection section 1950, 1952, 1958 for detecting the magnetic field.

If the circular display tube 1954 is transparent and the liquid 1962 has a color, the existence of magnetic field can be recognized easily.

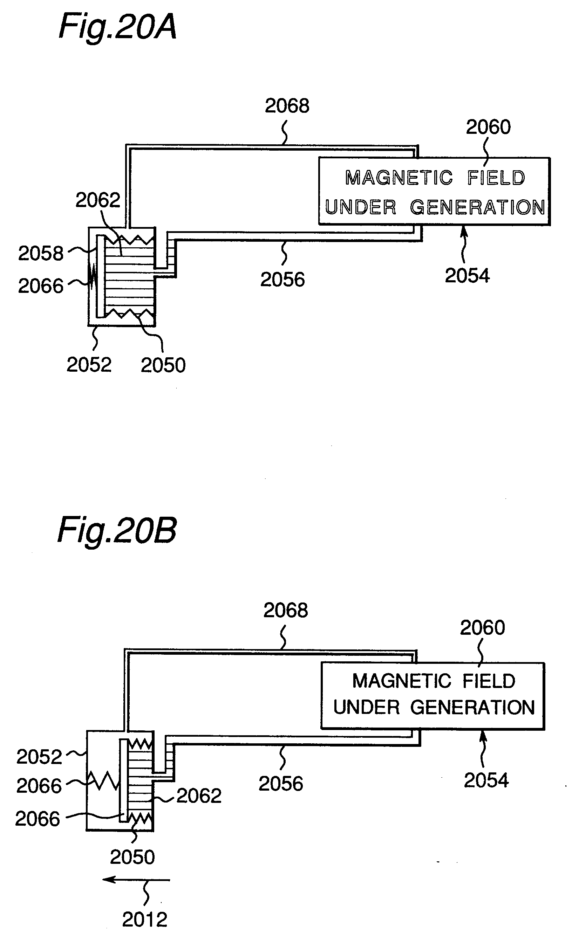

Fig. 20A is a sectional view of a magnetic field display apparatus according to a twentieth embodiment under no magnetic field, and Fig. 20B is a sectional view thereof under magnetic field. This apparatus is similar to that of the nineteenth embodiment. The apparatus comprises an inner case 2050 with a variable volume provided in an outer case 2052, a display device 2054 and a tube 2056, 2068. A magnetic plate 2058 is fixed to an end of the case 2050 to move the magnetic plate 2058 horizontally, while a spring 2066 is provided along a horizontal direction between the outer case 2052 and the magnetic plate 2058. A display section 2060 is provided in the display 2054 and the tube 2056 communicates the display section 2054 with the inner case 2050. Further, the other tube 2068 connects the display device 2054 to the outer case 2052. A liquid 2062 is filled in the inner case 2050, as shown in Fig. 19A. Then, when the liquid 25 moves through the tube 2056 toward the display device 2054, air returns through the other tube 2068 to the case 2052. The display section 2060 comprises a tube having a shape of a phrase "MAGNETIC FIELD UNDER GENERATION".

As shown in Fig. 20A, when no magnetic field is applied, the liquid 2062 remains in the inner case 2050, and the phrase is not observed in the display device 2054. On the other hand, when a magnetic field 2012 is applied, the volume of the inner case 2050 is determined by the spring force and the magnetic force, and it determines the amount of the liquid 2062 in the display device 2054. Then, the amplitude of magnetic field can be decided according to the amount of the liquid in the display device 2054. As shown in Fig. 20B, if the magnetic field is strong, the liquid 2062 fills to the top of the display section 2060, and the entire phrase can be observed.

In a modified example, a display section for displaying the existence of magnetic field and a detection section for detecting the magnetic field may be provided for, for example, each word of a phrase. Then, even if one of the detection sections malfunctions, words except the word of malfunction can be displayed. Thus, even if a malfunction occurs in the detection sections, the existence of magnetic field can be observed.

In the above-mentioned nineteenth and twentieth embodiments, the display device 1954, 2054 is observed only for one direction. However, for example, if the display tube in the nineteenth embodiment is spherical, it can be observed in many directions.

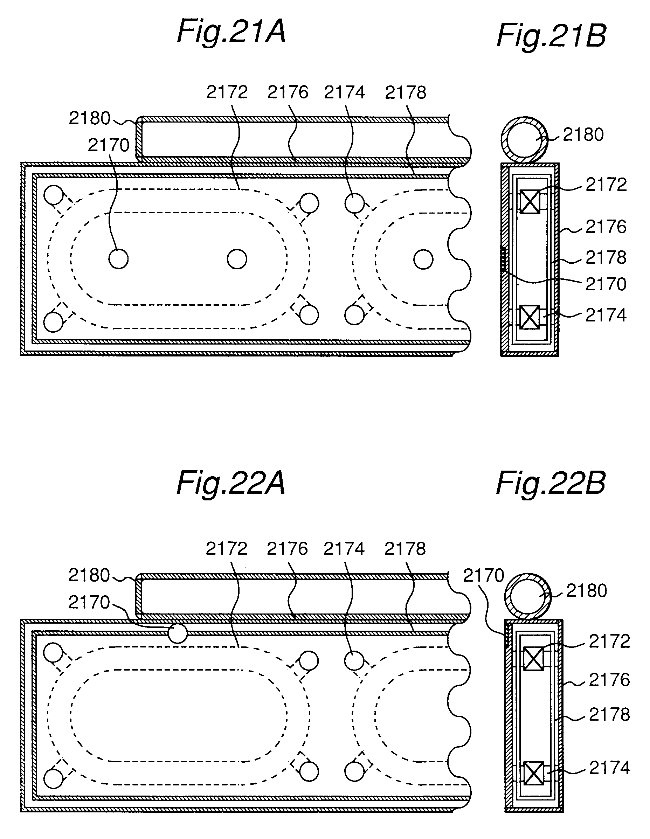

Fig. 21A is a vertical sectional view of a superconducting magnet, and Fig. 21B is a sectional view thereof. Magnetic field display apparatuses 2170 according to one of the first to twentieth embodiments are set near a superconducting magnet for a magnetic levitation train. A superconducting coil 2172 is set with four supports 2174 in a vessel 2176, and a thermal shield plate 2178 is set around the superconducting coils 2172 in the vessel 2176. Two magnetic field display apparatuses 2170 are provided for one superconducting magnet 2172 at recesses of the outer surface of the vessel 2176, as shown in Fig. 21B. A tank 2180 is provided at the outside of the vessel 2176.

If magnetic field display apparatuses 2170 are set at the outer surface of the vessel 2176, air resistance becomes large due to the unevenness of the outer surface of the vessel 2176 and the magnetic field display apparatuses 2170 when a magnetic levitation train runs. However, in this embodiment, the magnetic field display apparatuses 2170 are provided at recesses of the outer surface of the vessel 2176 to form a smooth outer surface. Then, air resistance does not increase due to the existence of the magnetic field display apparatuses 2170. That is, the existence of magnetic field can be displayed without increasing air resistance.

In the example explained above, two magnetic field display apparatuses 2170 are provided for one superconducting magnet 2172. However, the number of the magnetic field display apparatus 2070 may be one. Further, the positions of the recesses may be provided at various positions, such as at the center of the coil 2172 as shown in Fig. 21A or off the center.

Fig. 22A is a vertical sectional view of a superconducting magnet with a magnetic field display device 2070 according to one of the first to twentieth embodiments, and Fig. 22B is a sectional view thereof. This superconducting magnet is different from that of the twenty-first embodiment shown in Figs. 21A and 21B except that the position of the magnetic field display device 2170 is near a top edge of the magnet to form a smooth outer surface. One magnetic field display apparatus 2170 is provided for one superconducting magnet 2172. Then, air resistance does not increase due to the existence of the magnetic field display apparatuses 2170.

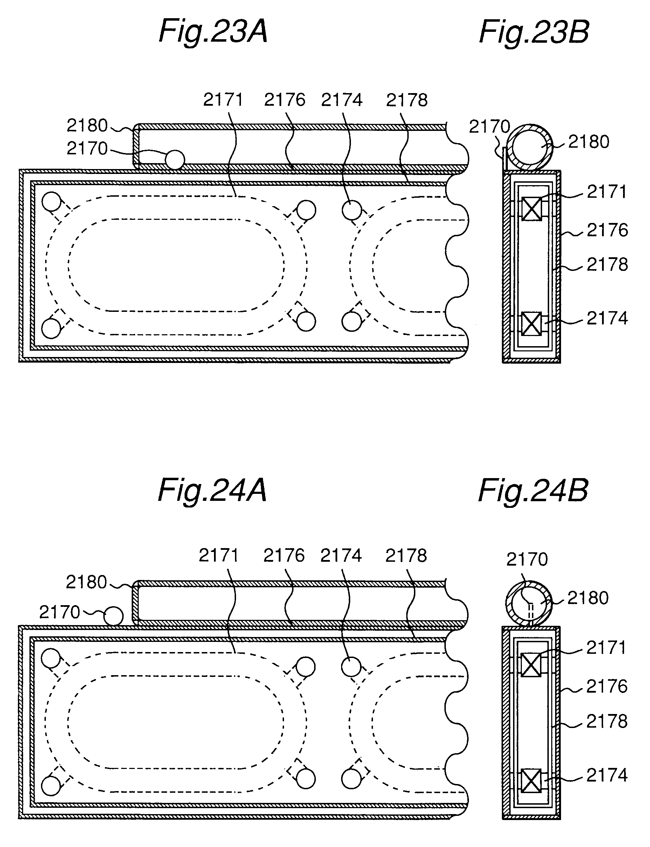

Fig. 23A is a vertical sectional view of a superconducting magnet with a magnetic field display device 2170 according to one of the first to twentieth embodiments, and Fig. 23B is a sectional view thereof. In this embodiment, the magnetic field display devices 2170 are set at a gap between the magnet and the tank 2180 so as to form a smooth continuous surface extending from the outer surface of the vessel 2176. Thus, air resistance does not increase due to the existence of the magnetic field display apparatuses 2170. Further, no excessive forming process for recesses is needed for the superconducting magnet.

Fig. 24A is a vertical sectional view of a superconducting magnet with a magnetic field display apparatus according to one of the first to twentieth embodiments, and Fig. 24B is a sectional view thereof. In this embodiment, the magnetic field display devices 2170 are set at a gap at the outside of the magnet or near the tank 2180 where the magnetic field display devices 2170 do not affect air resistance. Thus, a similar advantages to the last embodiment can be realized.

Although the present invention has been fully described in connection with the preferred embodiments thereof with reference to the accompanying drawings, it is to be noted that various changes and modifications are apparent to those skilled in the art. Such changes and modifications are to be understood as included within the scope of the present invention as defined by the appended claims unless they depart therefrom.

## Claims

1. An apparatus for displaying magnetic field comprising:
a case having a window;
a moving member contained in said case and comprises a magnetic material, said moving member being moved by magnetic field between a first position adjacent to the display window and a second position different from the first position; and
a means for displaying magnetic field by using said moving member to be moved by magnetic field.

2. The apparatus according to claim 1, wherein said moving member is moved in said case by a magnetic force exerting against the gravity.

3. The apparatus according to claim 1, further comprising a spring member connected between said moving member and said case so as to move said moving member between the first and second positions; wherein said spring member has a force to said moving member against a magnetic force of the magnetic field.

4. The apparatus according to claim 1, further comprising a rotation mechanism in said case to rotate said moving member around a rotation axis, wherein said means for displaying magnetic field displays magnetic field according to rotation of said moving member.

5. The apparatus according to claim 1, wherein said moving member is arranged to move between the first and second positions along the window.

6. The apparatus according to claim 1, wherein said case has a slope inclined from a horizontal direction, said moving member movable on the slope in magnetic field.

7. The apparatus for displaying magnetic field according to claim 1, comprising a plurality of the apparatuses according to claim 1, wherein the windows of said cases are arranged in a plane.

8. The apparatus according to claim 1, wherein said means for displaying magnetic field displays magnetic field with a character, a sign, a picture or a color.

9. An apparatus for displaying magnetic field, comprising:
a moving member comprising a magnetic material and moved by magnetic field;
a case having a volume changing according to movement of said moving member;
a display device connected to said case;
a liquid member contained in an inner space of said case and an inner space of said display device connected to each other;
wherein magnetic field is displayed by movement of said liquid member according to volume change of said case.

10. The device according to claim 9 wherein said means for displaying magnetic field displays magnetic field with a character, a sign, a picture or a color.
